# EUROPÄISCHE PATENTANMELDUNG

(11) **EP 1 359 619 A2**
(43) Veröffentlichungstag der Anmeldung: **05.11.2003**
(21) Anmeldenummer: 03008576.5
(22) Anmeldetag: 14.04.2003
(51) Int. Cl.: H01L 23/40

(54) **Kühlkörper für die Oberflächenmontagetechnologie**

(30) Priorität: 25.04.2002 DE 10218625; 17.06.2002 DE 10227047
(71) Anmelder: SIEMENS AKTIENGESELLSCHAFT, 80333 München (DE)
(72) Erfinder: Bast, Johannes, 91077 Neunkirchen (DE); Schulz, Wolfgang, 91325 Adelsdorf (DE); Standar, Robert, 91362 Pretzfeld (DE)

(57) **Zusammenfassung**

Es wird ein Kühlkörper (1) für elektronische Bauteile (3a, 3b, 3c) mit einer Kühlkörperkontaktfläche (7) zum Kontakt des Kühlkörpers (1) mit einem zu kühlenden Bauteil (3a, 3b, 3c) beschrieben. Der Kühlkörper (1) weist zumindest eine im Wesentlichen rechtwinklig zu der Kühlkörperkontaktfläche (7) an einer Unterseite des Kühlkörpers (1) angeordnete SMT-Befestigungsfläche (12) und eine im Wesentlichen rechtwinklig zu der Kühlkörperkontaktfläche (7) oberhalb der SMT-Befestigungsfläche (12) am Kühlkörper (1) angeordnete Saugfläche (10) für eine SMT-Pipette auf. In einer anderen Variante weist der Kühlkörper (1) zumindest einen sich von einer Oberseite des Kühlkörpers (1) aus in eine die Kühlkörperkontaktfläche (7) bildende Wandung (4) hinein erstreckenden Aufnahmeschlitz (14) zur Aufnahme eines Klammerelements (2) zum Festklammern des betreffenden Bauteils (3a, 3b) gegen die Kühlkörperkontaktfläche (7) auf. Außerdem wird ein geeignetes Klammerelement (2) für einen solchen Kühlkörper (1) beschrieben.

## Beschreibung

Die Erfindung betrifft einen Kühlkörper für elektronische Bauteile mit einer Kühlkörperkontaktfläche zum Kontakt des Kühlkörpers mit einem zu kühlenden Bauteil.

Um die in elektronischen Leistungsbauelementen wie beispielsweise Transistoren od. dgl. erzeugte Wärme möglichst effektiv abzuleiten und so eine Überhitzung des betreffenden Bauteils zu vermeiden, werden üblicherweise metallische Kühlkörper verwendet, die mit einer Kühlkörperkontaktfläche über eine wärmeleitende Verbindung mit dem betreffenden Bauteil verbunden sind und aufgrund ihrer guten Wärmeleitfähigkeit, ihrer Masse und ihrer Oberfläche die Wärme des Bauteils aufnehmen und an die Umgebung abstrahlen. In der Praxis ist eine Vielzahl von unterschiedlichsten Kühlkörpern bekannt, die jeweils an die Art und Form der zu kühlenden elektronischen Bauteile sowie den Einsatzzweck, insbesondere die abzuleitende Wärmemenge, den zur Verfügung stehenden Platz und die Montagemöglichkeiten angepasst sind. Bei der Montage einer umfangreicheren Schaltung mit vielen verschiedenen Leistungsbauelementen muss daher eine entsprechende Anzahl verschiedener Typen von Kühlkörpern mit unterschiedlichen Abmessungen und Formen zur Verfügung stehen. Um einen reibungslosen Produktionsablauf in einer Serienfertigung zu garantieren, ist daher für die Bereitstellung der benötigten Anzahl der unterschiedlichen Kühlkörpertypen ein größerer logistischer Aufwand und eine umfangreiche Lagerhaltung notwendig. Die Bestückung der Platinen mit den Kühlkörpern erfolgt dabei in der Regel manuell. Eine automatische Bestückung z. B. mittels sogenannter SMT-Montagetechnik (Surface Mounted Technology) ist bei der weitaus überwiegenden Anzahl der bekannten Kühlkörper leider nicht möglich. Aus der Praxis ist bisher lediglich ein SMT-bestückbarer Kühlkörper bekannt, welcher ein Doppel-T-förmiges Querschnittprofil aufweist und wie eine Brücke von oben auf das zu kühlende Bauteil aufgesetzt wird. Dieser Kühlkörper wird mit den Unterkanten seiner T-Stege, die die "Brückenpfeiler" bilden, auf entsprechenden Kontaktpads auf der Leiterplatte befestigt, wobei sich das Bauteil zwischen den T-Stegen befindet und die zwischen den T-Stegen befindliche Fläche das Bauteil kontaktiert. Diese Kühlkörper müssen von ihren Abmessungen her genau an die Abmessung des zu kühlenden Bauelements angepasst sein. Zudem ist die Verwendung dieser Kühlkörper nur zur Kühlung von SMD-Bauelementen (Surface Mounted Device) möglich, die entsprechend mit einem SMT-Verfahren liegend auf der Leiterplatte montiert sind. Eine Verwendung dieser Kühlkörper zur Kühlung von Leistungsbauelementen, die mittels eines THT-Verfahrens (Through Hole Technology), d. h. mit einer Durchstecktechnik, stehend auf der Leiterplatte montiert sind, ist nicht möglich. Sofern bei einer Schaltung verschiedene Leistungsbauelemente mit unterschiedlichen Techniken montiert sind, müssen folglich wieder verschiedene Kühlkörper mit den verschiedenen Techniken in aufeinanderfolgenden, separaten Verfahrensschritten montiert werden.

Es ist Aufgabe der vorliegenden Erfindung, einen alternativen Kühlkörper zu schaffen, welcher möglichst universell einsetzbar ist und insbesondere zur Kühlung verschiedenster Bauelemente dienen kann und mit unterschiedlichsten Technologien bestückt werden kann.

Diese Aufgabe wird durch einen Kühlkörper gemäß Patentanspruch 1 und durch einen Kühlkörper gemäß Patentanspruch 12 gelöst.

Nach der ersten erfindungsgemäßen Variante weist der Kühlkörper zumindest eine im Wesentlichen rechtwinklig zu der Kühlkörperkontaktfläche an einer Unterseite des Kühlkörpers angeordnete SMT-Befestigungsfläche auf. Mit einem solchen "Befestigungs-Pin" kann der Kühlkörper auf einem entsprechend auf der Leiterplatte angeordneten Kontaktpad mit üblichen SMT-Verfahren wie Automaten- oder Druck-Klebeprozessen oder innerhalb eines Reflow-Lötprozesses befestigt werden.

Außerdem weist der Kühlkörper eine im Wesentlichen rechtwinklig zu der Kühlkörperkontaktfläche oberhalb der SMT-Befestigungsfläche am Kühlkörper angeordnete Saugfläche für eine SMT-Pipette auf, so dass der Kühlkörper beispielsweise mittels eines üblichen Pick-und-Place-Bestückautomaten bestückbar ist. Durch die Anordnung der SMT-Befestigungsflächen und der Saugfläche im Wesentlichen rechtwinklig zur Kühlkörperkontaktfläche ist es möglich, den Kühlkörper in stehender Form, d. h. in senkrechter Montage mit einer an einem üblichen THT-Leistungshalbleiter anliegenden Kühlkörperkontaktfläche, automatisch zu bestücken. Darüber hinaus ist der Kühlkörper aber auch liegend bestückbar, da die Rückseite der Kühlkörperkontaktfläche sich ebenfalls sehr gut zum Erfassen des Kühlkörpers mittels einer SMT-Pipette eignet und der Kühlkörper somit auch z. B. auf einen SMD-Leistungshalbleiter aufgesetzt werden kann. Der Kühlkörper ist folglich zur Kühlung einer Vielzahl von unterschiedlichen Typen von Leistungsbauteilen, welche auf unterschiedlichste Weise auf der Leiterplatte montiert sein können, geeignet.

Nach der zweiten erfindungsgemäßen Variante weist der Kühlkörper zumindest einen sich von einer Oberseite des Kühlkörpers aus in eine die Kühlkörperkontaktfläche bildende Wandung hinein erstreckenden Aufnahmeschlitz auf, der zur Aufnahme eines Klammerelements zum Festklammern des betreffenden Bauteils gegen die Kühlkörperkontaktfläche dient. Dadurch ist eine sehr einfache und schnelle Befestigung der zu kühlenden Bauteile an der betreffenden Kühlkörperkontaktfläche möglich, indem einfach - bei einer stehenden Montage des Kühlkörpers von oben - ein Klammerelement in den Schlitz eingeschoben wird. Ein aufwändiges Verschrauben der zu kühlenden Bauelemente mit dem Kühlkörper ist nicht mehr notwendig. Dabei ist insbesondere die Möglichkeit gegeben, mehrere solcher Kühlkörper modulartig in einer Flucht nebeneinander einzusetzen und mit entsprechendem Einschieben von Klammerelementen in die passenden Aufnahmeschlitze auch Bauelemente unterschiedlicher Breite an der Kühlkörperreihe sicher zu befestigen. Dadurch kann der erfindungsgemäße Kühlkörper für Bauelemente unterschiedlicher Breiten eingesetzt werden.

Die jeweiligen abhängigen Ansprüche enthalten besonders vorteilhafte Ausgestaltungen und Weiterbildungen der Erfindung.

Besonders bevorzugt ist der Kühlkörper so ausgebildet, dass er sowohl die Merkmale der ersten erfindungsgemäßen Variante als auch die Merkmale der zweiten erfindungsgemäßen Variante aufweist. Ein solcher Kühlkörper ist besonders universell einsatzfähig.

Bei einer bevorzugten Ausführungsform ist die SMT-Befestigungsfläche über ein die Wärmeleitung behinderndes Element mit dem Kühlkörper verbunden. Eine solche "Wärmefalle" sorgt dafür, dass bei einem starken Erhitzen des Kühlkörpers wegen einer hohen Temperatur des zu kühlenden Bauelements die SMT-Befestigungsflächen selbst relativ kalt bleiben und daher die Lötverbindung zwischen den SMT-Befestigungsflächen und der Leiterplatte nicht erweicht wird. Somit ist auch bei höheren Temperaturen des Kühlkörpers eine feste Verbindung zwischen dem Kühlkörper und der Leiterplatte gewährleistet. Eine weitere Funktion erfüllt die Wärmefalle, wenn der SMT-Kühlkörper nur mit einem kleinen Befestigungspad auf der Leiterplatte gelötet wird. Dann wird für die Reflow-Lötung der Wärmebedarf reduziert und der SMT-Kühlkörper ist sicher befestigt. Ein solches, die Wärmeleitung behinderndes Element lässt sich relativ einfach dadurch realisieren, dass die SMT-Befestigungsfläche nur über einen dünnen Steg mit dem Kühlkörper verbunden ist.

Bei einer besonders einfach zu fertigenden, bevorzugten Form weist der Kühlkörper in einer parallel zur SMT-Befestigungsfläche liegenden Ebene ein im Wesentlichen U-förmiges Profil auf. Eine Außenseite der die U-Grundfläche bildenden Wandung des U-Profils bildet dabei die Kühlkörperkontaktfläche, und die beiden die U-Schenkel bildenden Seitenwandungen des U-Profils bilden außenseitig die den Kühlkörper seitlich begrenzenden Seitenflächen. Die beiden Seitenflächen stehen dabei im Wesentlichen rechtwinklig zu der Kühlkörperkontaktfläche. Bei einer bevorzugten Ausführungsform ist an jeder der beiden Seitenflächen an einem unteren Ende jeweils eine SMT-Befestigungsfläche angeordnet, wobei besonders bevorzugt die SMT-Befestigungsflächen von den unteren Enden der beiden Seitenwandungen aus in eine durch das U-Profil definierte Grundfläche hineinragen, d. h. nicht seitlich über die Seitenflächen herausragen. Beim modularen Aneinanderreihen der Kühlkörper, bei dem die Kühlkörperkontaktflächen eine Flucht bilden, können daher die einzelnen Kühlkörper mit ihren Seitenflächen direkt aneinander anliegend gesetzt werden. Damit ist auch ein guter Wärmeaustausch der Kühlkörper untereinander gegeben.

Weiterhin ist der Kühlkörper bevorzugt so ausgebildet, dass eine untere Kante der die U-Grundfläche bildenden Wandung als eine zweite Kühlkörperkontaktfläche nach unten bündig mit den SMT-Befestigungsflächen 12 abschließt. Diese über die zunächst genannte erste , große Kühlkörperkontaktfläche hinaus vorhandene relativ kleine, zweite Kühlkörperkontaktfläche kann genutzt werden, wenn der Kühlkörper zur Kühlung eines SMD-Bauelements verwendet werden soll, das über den Kontaktpad des SMD-Bauelements gekühlt wird, da diese zweite Kühlkörperkontaktfläche dann direkt auf den Kontaktpad des betreffenden Bauelements aufgesetzt werden kann. Ein derartiger Kühlkörper ist folglich nicht nur zur Kühlung von stehend angeordneten THT-Bauelementen und zum liegenden Einbau auf SMD-Bauelementen verwendbar, die obenseitig gekühlt werden, sondern auch für solche SMD-Bauelemente, welche nach unten über den Kontaktpad gekühlt werden.

Die Saugfläche des Kühlkörpers kann im Prinzip an einer beliebigen Position oberhalb, d. h. auch seitlich oberhalb der SMT-Befestigungsflächen angeordnet sein. Vorzugsweise ist die Saugfläche des Kühlkörpers jedoch an einem oberen Ende zumindest einer der beiden Seitenwandungen angeordnet, wobei das obere Ende definitionsgemäß das Ende ist, welches dem Ende der betreffenden Seitenwandung, an dem die SMT-Befestigungsfläche angeordnet ist, gegenüber liegt.

Die Saugfläche kann sich dabei von dem oberen Ende der betreffenden Seitenwandung aus in Richtung des oberen Endes der anderen Seitenwandung hin erstrecken, so dass die Saugfläche sich ebenfalls in die durch das U-Profil definierte Querschnittsfläche - hinter der die Kühlkörperkontaktfläche bildenden Wandung - erstreckt. Bei diesem Aufbau befindet sich die Saugfläche direkt über dem Schwerpunkt des Kühlkörpers bzw. über der durch die SMT-Befestigungsflächen definierten Standfläche. Der Kühlkörper ist daher vom Bestückungsautomaten relativ unkompliziert zu platzieren, ohne dass die Gefahr des Umkippens besteht.

Dabei erstreckt sich besonders bevorzugt die Saugfläche in einem Abstand zu der die U-Grundfläche bildenden Wandung. Das heisst, es besteht ein Abstand zwischen der Wandung, welche die Kühlkörperkontaktfläche bildet, und der Saugfläche. Bei einer Ausbildung des Kühlkörpers in einer kombinierten Variante mit SMT-Saugfläche und mit senkrechten Aufnahmeschlitzen für die Klammerelemente in der die Kühlkörperkontaktfläche bildenden Wandung sind dann die Aufnahmeschlitze von beiden Seiten der Wandung frei zugänglich, und die Klammerelemente können ungehindert an der Saugfläche vorbei von der Oberseite aus in die Aufnahmeschlitze des Kühlkörpers eingeschoben werden.

Die Aufnahmeschlitze verlaufen vorzugsweise parallel zu einer an die Kühlkörperkontaktfläche angrenzenden Seitenfläche des Kühlkörpers. Dabei ist besonders bevorzugt bei einem Kühlkörper mit im Wesentlichen rechtwinklig zu der Kühlkörperkontaktfläche angeordneten Seitenflächen jeweils in einem kurzen Abstand zu den Seitenflächen ein Aufnahmeschlitz in der die Kühlkörperkontaktfläche bildenden Wandung angeordnet. D. h. der Kühlkörper weist dann sowohl am rechten als auch am linken Rand in seiner Kühlkörperkontaktfläche einen parallel zu der Seitenfläche verlaufenden Schlitz auf, so dass wahlweise ein Klammerelement in den rechten oder in den linken Schlitz eingesteckt werden kann. Dies hat Vorteile, wenn die Kühlkörper als Module zur Kühlung eines breiteren Bauelements nebeneinander gestellt werden, da so beispielsweise ein sich im Wesentlichen über zwei Kühlkörperbreiten erstreckendes Bauelement an dem einen Kühlkörper von rechts und an dem anderen Kühlkörper von links geklammert werden kann, um einen festen Kontakt zu den Kühlkörpern herzustellen.

Bei einem besonders bevorzugten Ausführungsbeispiel erstreckt sich die die Kühlkörperkontaktfläche bildende Wandung in einem Teilbereich, vorzugsweise genau in dem Teilbereich zwischen den beiden Aufnahmenschlitzen, über die Saugfläche bzw. die oberen Enden der Seitenwandungen des Kühlkörpers hinaus nach oben und bildet so eine Kühlkörpererweiterungszunge. An dieser Kühlkörpererweiterungszunge können dann weitere Kühlkörper zur Erweiterung der Kühlkapazität befestigt werden. Insbesondere ist es dabei möglich, mehrere erfindungsgemäße Kühlkörper in einem entsprechendem Rastermaß auf einer Leiterplatte zu montieren und einen üblichen Summenkühlkörper mit einer Vielzahl von Kühlrippen aufzulegen. Dabei kann der Erweiterungskühlkörper über übliche Federkontakte, die zwischen die Rippen des Erweiterungskühlkörpers eingeschoben werden und die Kühlkörpererweiterungszungen gegen eine Rippe drücken, an den erfindungsgemäßen Kühlkörpern befestigt werden.

Um eine gute Wärmeleitfähigkeit auch für Anwendungen (HF) zu erreichen, in denen Null-Ohm Verbindungen durch löten gefordert werden, besteht der Kühlkörper vorzugsweise aus Messing oder Bronze. Bei einem besonders bevorzugten Ausführungsbeispiel ist der Kühlkörper einteilig aus einem Blechzuschnitt gebogen, d. h. es ist keinerlei Verschraubung oder Verlötung von einzelnen Kühlkörperteilen zur Bildung des Kühlkörpers notwendig. Damit ist eine sehr kostengünstige Herstellung möglich. Durch eine komplette Verzinnung des Kühlkörpers wird erreicht, dass der Kühlkörper in einem Reflow-Ofen problemlos mit den Kontaktpads auf der Leiterplatte verbunden werden kann und auch aneinandergereihte Kühlkörper sich miteinander fest verbinden und so einen sehr stabilen, großen Kühlkörperaufbau bilden.

Ein besonders einfaches und kostengünstig herstellbares Klammerelement zum Einstecken in einen Aufnahmeschlitz in einen der erfindungsgemäßen Kühlkörper zum Festklammern eines Bauelements weist einen Einstecksteg auf, der bezüglich seiner Dicke an die Breite des Aufnahmeschlitzes des Kühlkörpers und bezüglich seiner Länge an die Dicke der die Kühlkörperkontaktfläche bildenden Wandung sowie die Dicke des festzuklammernden Bauelements angepasst ist. An einem Ende des Einsteckstegs ist ein federndes Andruckelement angeordnet, welches im montierten Zustand gegen das Bauelement drückt. Im anderen Endbereich des Einsteckstegs ist ein Wiederlageelement angeordnet, welches in montiertem Zustand an der die Kühlkörperkontaktfläche bildenden Wandung des Kühlkörpers anliegt.

Ein solches Klammerelement ist ebenfalls relativ einfach in einem Teil durch entsprechendes Biegen aus einem Blechzuschnitt herstellbar. Das Klammerelement ist vorzugsweise aus Bronze oder einem anderen federnden Material wie z. B. Federstahl gefertigt.

Die zwei Wiederlagerelemente erstrecken sich vorzugsweise jeweils rechtwinklig vom Einstecksteg aus sowie rechtwinklig zu einer Einsteckrichtung in einander entgegengesetzte Richtungen. Dabei erstrecken sich die Wiederlageelemente besonders bevorzugt in parallelen Ebenen, die in einem solchen Abstand zueinander angeordnet sind, der an die Dicke der die Kühlkörperkontaktfläche bildenden Wandung des Kühlkörpers angepasst ist. D. h. eines der beiden Wiederlageelemente befindet sich im eingestecktem Zustand an der Außenseite der betreffenden Wandung und eines an der Innenseite, so dass ein besonders sicherer Halt des Klammerelements in dem Aufnahmeschlitz des Kühlkörpers gegeben ist.

Die Erfindung wird im Folgenden unter Hinweis auf die beigefügten Figuren anhand von Ausführungsbeispielen näher erläutert. Aus den beschriebenen Beispielen sowie den Zeichnungen ergeben sich weitere Vorteile, Merkmale und Einzelheiten der Erfindung. Es zeigen:
- Figur 1: eine perspektivische rückseitige Darstellung eines erfindungsgemäßen Kühlkörpers,
- Figur 2: eine perspektivische Darstellung eines erfindungsgemäßen Klammerelements,
- Figur 3: eine Draufsicht auf den Kühlkörper gemäß Figur 1 mit eingestecktem Klammerelement gemäß Figur 2,
- Figur 4: eine perspektivische Frontansicht einer Gruppe von erfindungsgemäßen Kühlkörpern, die Bauelemente unterschiedlicher Breite kühlen,
- Figur 5: eine perspektivische Ansicht der Gruppe von Kühlkörpern gemäß Figur 4 von der Rückseite aus gesehen,
- Figur 6: eine perspektivische Ansicht einer Mehrzahl von in einem bestimmten Rastermaß in Reihen und Spalten in senkrechter Stellung auf einer Leiterplatte montierten Kühlkörpern,
- Figur 7: eine perspektivische Darstellung der Kühlkörperanordnung gemäß Figur 6 mit einem aufgesteckten Summenkühlkörper gemäß einem ersten Ausführungsbeispiel,
- Figur 8: eine perspektivische Darstellung der Kühlköperanordnung gemäß Figur 6 mit einem aufgesteckten Summenkühlkörper gemäß einem zweiten Ausführungsbeispiel,
- Figur 9: eine rückseitige, perspektivische Ansicht eines Kühlkörpers, welcher ein SMD-Leistungsbauelement über ein Leiterplattenkontaktpad von unten kühlt,
- Figur 10: eine perspektivische Ansicht zweier erfindungsgemäßer Kühlkörper, die mit ihren Seitenflächen an einem zu kühlenden SMD-Leistungsbauelement anliegen,
- Figur 11: eine perspektivische Ansicht eines erfindungsgemäßen Kühlkörpers, der in liegender Bauweise auf der Oberseite eines zu kühlenden SMD-Bauelements montiert ist,
- Figur 12: einen erfindungsgemäßen Kühlkörper, der in liegender Bauweise eine Gruppe von vier SMD-Leistungsbauelementen kühlt.

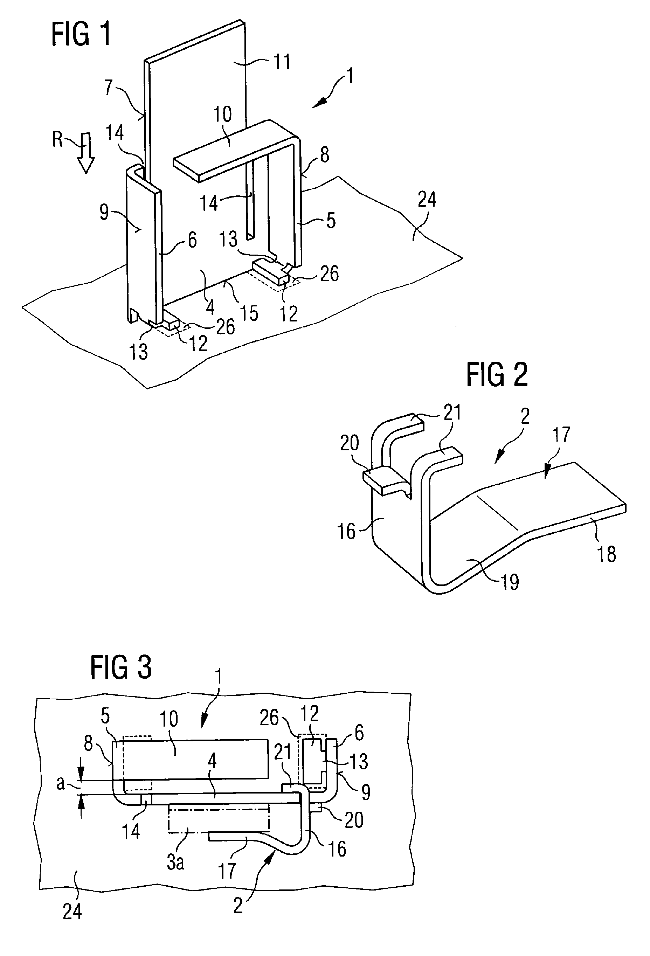

Bei dem in den Figuren dargestellten Ausführungsbeispiel weist der Kühlkörper 1, wie insbesondere die Figuren 1 und 3 deutlich zeigen, von oben betrachtet ein im Wesentlichen U-förmiges Querschnittprofil auf.

Die Außenseite der die U-Grundfläche bildenden Wandung 4 des U-Profils ist dabei die eigentliche Kühlkörperkontaktfläche 7. Die die U-Schenkel des U-Profils bildenden Seitenwandungen 5, 6 bilden außenseitig zwei rechtwinklig zur Kühlkörperkontaktfläche 7 stehende Seitenflächen 8, 9, die den Kühlkörper 1 seitlich begrenzen.

An den unteren Enden der Seitenwandungen 5, 6 ist jeweils über einen dünnen Steg 13, welcher als Wärmefalle dient, eine SMT-Befestigungsfläche 12 angeordnet, wobei die Stege 13 sich jeweils nach innen, d. h. in Richtung der durch das U-Profil definierten Grundfläche erstrecken, so dass sich die SMT-Befestigungsflächen 12 innerhalb dieser Grundfläche befinden. An diesen SMT-Befestigungsflächen 12 wird der Kühlkörper 1 bei einer stehenden Montage, wie dies in den Figuren 1, 3 sowie 4 bis 10 gezeigt ist, an Kontaktpads 26 mit einer Leiterplatte 24 verbunden. Die Wärmefalle sorgt dafür, dass sich bei einer starken Erhitzung des Kühlkörpers 1 die SMT-Befestigungsflächen 12 nicht in gleichem Maße mit erwärmen und die Verbindung zwischen den SMT-Befestigungsflächen 12 und den Kontaktpads 26 der Leiterplatte 24 lösen kann. Sie sorgt außerdem für eine sichere Lötung in der Reflow-Lötanlage, damit nicht so hoher Wärmebedarf für die Vorwärmung der Kühlkörper nötig ist.

Die Unterkante 15 der die Kühlkörperkontaktfläche 7 bildenden Wandung 4, d. h. der U-Grundfläche, schließt nach unten bündig mit den SMT-Befestigungsflächen 12 ab, so dass die Unterkante 15 auf der Leiterplatte 24 aufliegt, wenn der Kühlkörper 1 auf eine Leiterplatte gestellt wird und an den SMT-Befestigungsflächen 12 auf der Leiterplatte befestigt wird. Nach oben ragt diese Wandung 4 unter Bildung einer Kühlkörpererweiterungszunge 11 in einem mittleren Bereich über die Seitenwandung 5, 6 heraus. Rechts und links neben diesem sich nach oben hinaus erstreckenden Bereich 11 befinden sich zwei parallel in einem kurzen Abstand neben den Seitenflächen 8, 9 verlaufende Aufnahmeschlitze 14. Diese Aufnahmeschlitze 14 dienen zur Aufnahme eines Klammerelements 2 gemäß Figur 2, das - wie in Figur 3 dargestellt - von oben eingeschoben wird.

An dem oberen Ende der einen Seitenwandung 5 erstreckt sich in Richtung der anderen Seitenwandung 6 in einem Abstand a hinter der Kühlkörpererweiterungszunge 11 ebenfalls rechtwinklig zur Kühlkörperkontaktfläche, d. h. parallel oberhalb der beiden SMT-Befestigungsflächen 12, eine Lasche, die eine Saugfläche 10 für eine SMT-Pipette bildet. Diese Saugfläche 10 ist die Pick-und-Place-Abholfläche für die Saugpipette eines SMT-Bestückungsautomaten, mit dem der Kühlkörper in der in den Figuren 1, 3 sowie 4 bis 10 gezeigten Anordnung stehend auf der Leiterplatte 24 montiert werden kann.

Der Abstand a zwischen der Saugfläche 10 und der Wandung 4, welche die Kühlkörperkontaktfläche 7 bildet, ist so breit gewählt, dass das Klammerelement 2 wie in Figur 2 gezeigt, unbehindert von oben sowohl in den rechten als auch in den linken Aufnahmeschlitz 14 eingesteckt werden kann.

Der gesamte Kühlkörper 1 ist aus einem einzelnen Bronze- oder Messingblechausschnitt gebogen, indem zunächst die beiden Seitenwandungen 6 U-förmig von der die Kühlkörperkontaktfläche 7 bildenden U-Grundflächenwandung 4 im rechten Winkel weggebogen werden und anschließend die beiden SMT-Befestigungsflächen 12 an ihren Stegen 13 sowie die die Saugfläche 10 bildende Lasche von den Seitenwandungen 5, 6 nach innen in das U-Profil hineingebogen werden. Anschließend wird der gesamte Kühlkörper verzinnt.

Das zugehörige Klammerelement 2, das zum Festklammern eines zu kühlenden Bauelements 3a, 3b an der Kühlkörperkontaktfläche 7 bei einer stehenden Montageweise dient, ist in Figur 2 dargestellt.

Es besteht aus einem Einstecksteg 16, an dem vorderseitig, d. h. an dem in der montierten Stellung außenseitig vor der Kühlkörperkontaktfläche 7 des Kühlkörpers 1 befindlichen Ende, eine Andruckzunge 17 angeformt ist, die federnd ausgebildet ist.

Am hinteren Ende des Einsteckstegs 16 befinden sich Wiederlageelemente 20, 21, welche, wie in Figur 3 dargestellt, in montiertem Zustand vor und hinter die die Kühlkörperkontaktfläche 7 bildende Wandung 4 des Kühlkörpers 1 greifen und so für einen festen Sitz des Klammerelements 2 innerhalb des Aufnahmeschlitzes 14 des Kühlkörpers 1 sorgen.

Das Klammerelement gemäß Figur 2 ist einstückig aus einem Bronze-Blechausschnitt gebogen. Um eine federnde Wirkung zu erzielen, ist die Andruckzunge 17 aus zwei Teilabschnitten 18, 19 aufgebaut, wobei der erste, am Einstecksteg 16 angeordnete Teilabschnitt 19 so vom Einstecksteg 16 weggebogen ist, dass er in montiertem Zustand von außen schräg in Richtung des montierten Bauteils 3a (siehe Figur 3) weist. Der zweite äußere Teilabschnitt 18 ist wiederum in einem leichten Winkel von dem ersten Teilabschnitt 19 weggebogen, so dass er parallel zur Oberfläche des zu kühlenden Bauteils 3a verläuft und flach an die Oberfläche des betreffenden Bauteils 3a andrückt.

Zur Bildung der Wiederlageelemente 21 ist der Einstecksteg von seinem hinteren Ende aus parallel in Erstreckungsrichtung des Einsteckstegs 16 zweifach geschlitzt. Ein zwischen den Schlitzen befindlicher Mittelteil ist dann nach außen rechtwinklig zum Einstecksteg 16 umgebogen, und zwar in eine Richtung entgegengesetzt zu der Erstreckungsrichtung der Andruckzunge 17. Parallel dazu in einer versetzten Ebene sind die beiden äußeren Endteile des Einsteckstegs 16 jeweils in die entgegengesetzte Richtung, d. h. parallel in Erstreckungsrichtung der Andruckzunge 17, rechtwinklig umgebogen. Der Abstand zwischen den parallelen Ebenen, in denen die Wiederlageelemente 21 und 20 umgebogen sind, ist an die Dicke der Wandung 4 des Kühlkörpers 1 mit den Aufnahmeschlitzen 14 angepasst.

Der in den Figuren dargestellte Kühlkörper ist universell für verschiedenste SMT- und THT-Leistungsbauelemente einsetzbar. Er kann mittels SMT-Montagetechnik in jeder beliebigen Richtung automatisch gesetzt werden. Dabei ist es möglich, die Kühlkörper 1 magaziniert oder in Stangen konfektioniert dem Bestückungsautomaten zuzuführen.

Bei einer besonders bevorzugten Ausführungsform beträgt das Gewicht der Kühlkörper nicht mehr als 13 g, und die Höhe des gesamten Kühlkörpers beträgt nicht mehr als 20 mm, so dass die üblichen Bestückungsautomatenanforderungen erfüllt sind und folglich keine besonderen Bestückungsautomaten verwendet werden müssen.

Durch die Verwendung von Bronze- oder Messingblech, welches anschließend verzinnt wurde, ist der Kühlkörper 1 rundum gut lötfähig, d. h. die Kühlkörper 1 können auch vollflächig auf das zu kühlende Bauteil gelötet werden, was besonders bei HF-Anwendungen wichtig ist. Durch die kompakte, von außen genau rechtwinklig begrenzte Bauform sind die Kühlkörper 1 beliebig als Module aneinanderreihbar. Durch die vollflächige Verzinnung werden die Kühlkörper im aneinandergereihten Zustand im Übrigen in einem Reflow-Ofen automatisch so untereinander verbunden, dass ein stabiler Aufbau einer Kühlkörperreihe erzeugt wird, ohne dass hierfür ein Mehraufwand in der Prozesskette erforderlich wäre, wie beispielsweise ein Verschrauben oder Verklammern der einzelnen Kühlkörpermodule gegeneinander.

Durch die Möglichkeit einer SMT-Montage in stehender Weise mit sehr großer, senkrecht stehender Kühlkörperkontaktfläche 7 können insbesondere auch die klassisch in stehender Weise montierten THT-Leistungsbauelemente 3a, 3b gekühlt werden. Dabei ist insbesondere auch bei dieser Variante aufgrund der speziellen Ausgestaltung der Kühlkörper 1 eine automatische Bestückung möglich. Hierbei werden zunächst in einem Arbeitsgang die Platinen 24 mit den erfindungsgemäßen Kühlkörpern 1 bestückt und beispielsweise in einem automatischen oder Druck-Klebeprozess oder in einem Reflow-Lötofen auf der Leiterplatte 24 befestigt. Die THT-Leistungsbauelemente 3a, 3b werden dann an den SMT-Prozess anschließend bestückt und schließlich mit den Klammerelementen 2 an den erfindungsgemäßen Kühlkörper 1 gepresst, wie dies in den Figuren 3 bis 8 dargestellt ist.

Um einen guten Wärmeübergang vom Bauelement 3a, 3b zu dem erfindungsgemäßen Kühlkörper 1 sicherzustellen, gibt es mehrere Varianten. Zum einen kann die Kühlkörperkontaktfläche 7 mit einem Wärmeleitband ausgestattet sein, das elektrisch isolierend ist. Zum anderen kann die Kühlkörperkontaktfläche mit elektrisch leitendem Wärmeleitband ausgestattet sein. Für eine Null-Ohm-Verbindung kann die Kühlkörperkontaktfläche auch einfach an das Bauelement entsprechend gut gelötet sein.

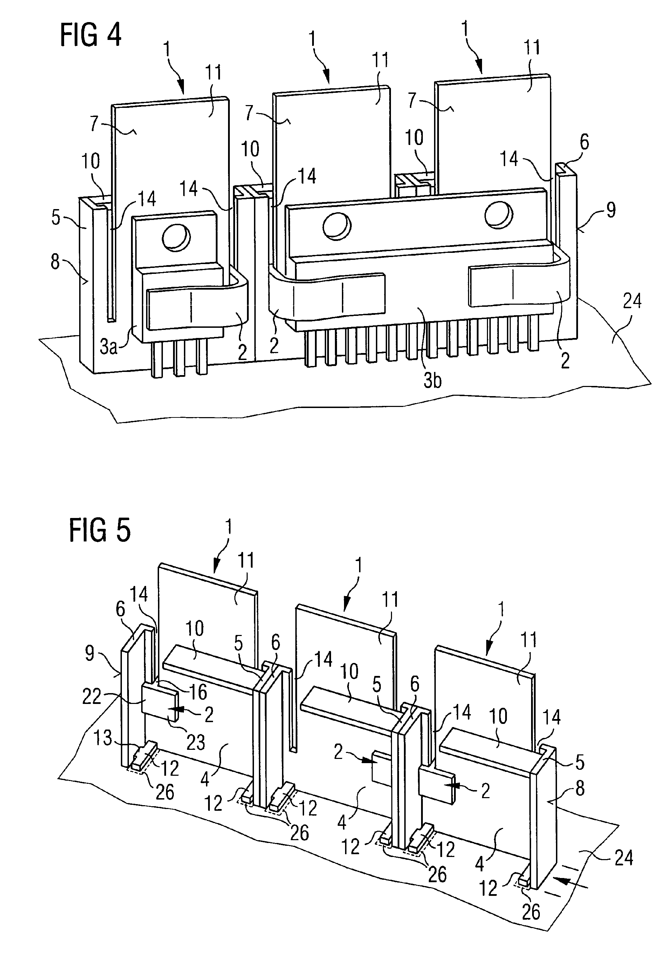

Die Figuren 4 bis 8 zeigen jeweils verschiedene Montagevarianten zur Kühlung von typischen THT-Leistungshalbleitern 3a, 3b, welche senkrecht auf eine Platine 24 montiert sind. Die Figuren zeigen dabei sehr deutlich die Möglichkeit, den erfindungsgemäßen Kühlkörper 1 modular einzusetzen und beispielsweise, wie hier dargestellt, mit einem Kühlkörper 1 einen relativ schmalen Leistungshalbleiter 3a oder auch mit zwei Kühlkörpern 1 einen breiten Leistungshalbleiter 3b zu kühlen. Durch die Schlitzung rechts und links neben den Seitenflächen 8, 9 besteht dabei die Möglichkeit, den Leistungshalbleiter 3a, 3b wahlweise von rechts, von links oder auch von rechts und links zu klammern. Der Kühlkörper 1 sollte hierzu von seiner Breite und von dem Abstandsmaß zwischen den Aufnahmeschlitzen her an das übliche Rasterbreitenmaß der gängigen Leistungshalbleiter angepasst sein.

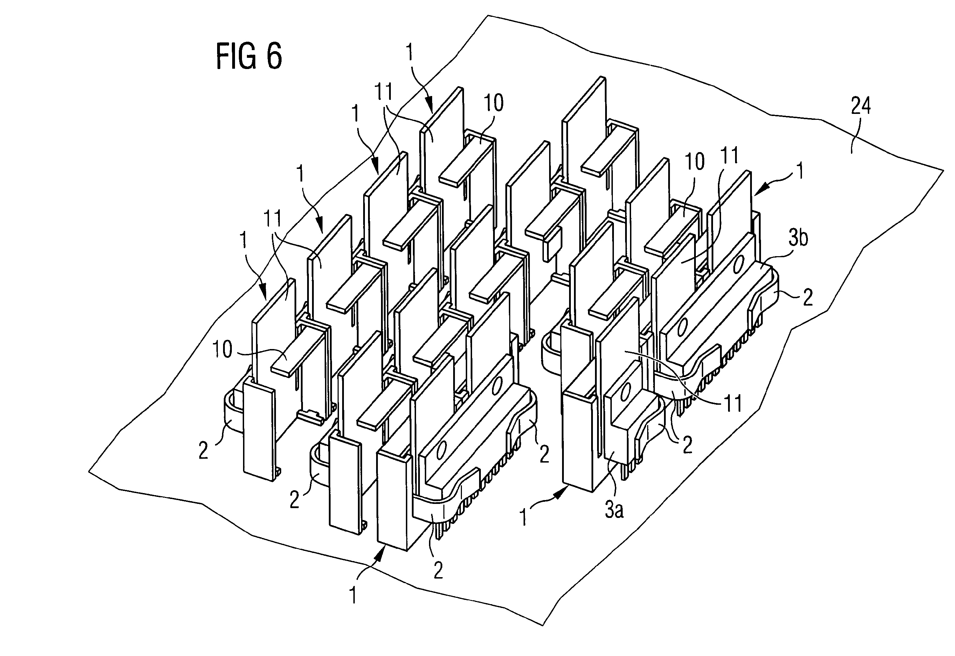

Figur 5 zeigt das gleiche Ausführungsbeispiel noch einmal von hinten betrachtet. Bei diesem Ausführungsbeispiel wird, wie dies in Figur 5 zu sehen ist, ein zweites Ausführungsbeispiel eines Klammerelements 2 verwendet. Der wesentliche Unterschied zu dem Ausführungsbeispiel gemäß Figur 2 besteht hier darin, dass die Wiederlageelemente 22, 23 sich in einer Ebene befinden und nur von hinten gegen die die Kühlkörperkontaktfläche 7 bildende Wandung 4 des Kühlkörpers 1 drücken. Die Variante gemäß Figur 2 ist demgegenüber etwas stabiler, weil diese Klammerelemente 2 auch ohne einen Druck auf das federnde Andruckelement 17 fest an der Position innerhalb des Aufnahmeschlitzes 14 gehalten werden.

In Figur 5 ist außerdem durch einen Pfeil dargestellt, wie die erfindungsgemäßen Kühlkörper 1 prinzipiell innerhalb einer Stangengebindeführung einem Bestückungsautomaten zugeführt werden können, so dass die SMT-Pipette des Bestückungsautomaten die Kühlkörper 1 an ihren SMT-Saugflächen 10 fassen kann und auf eine Leiterplatte 24 aufsetzen kann.

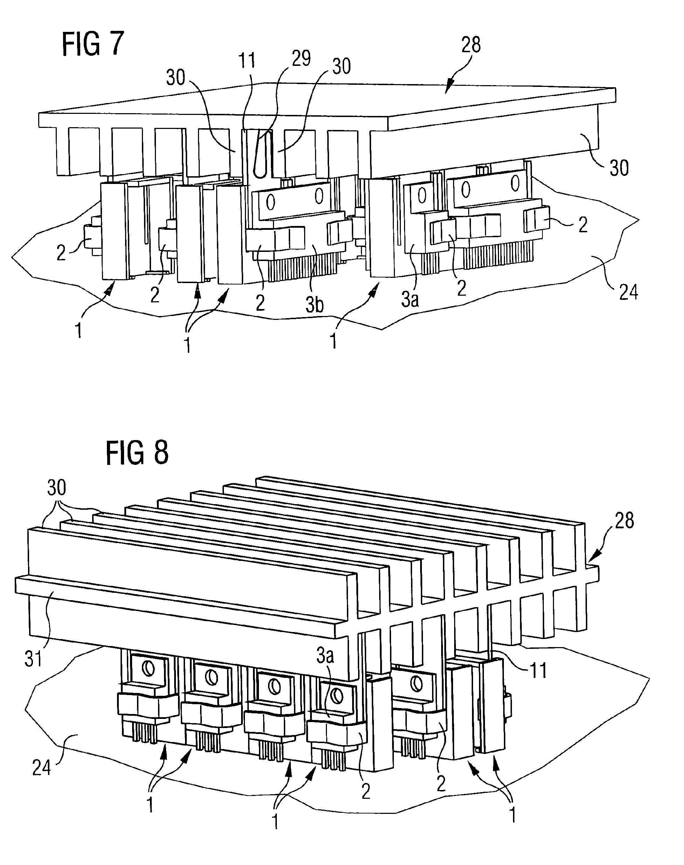

Die Figuren 6 bis 8 zeigen verschiedene Gruppierungen von möglichen Gegeneinander- und Aneinanderreihungen der erfindungsgemäßen Kühlkörper 1. Die Anordnung der Kühlkörper 1 erfolgt hier vorzugsweise in einem genormten Rastermaß, so dass, wie in den Figuren 7 und 8 dargestellt, auf die Kühlkörpererweiterungszungen 11 der Kühlkörper 1 einfache Summenkühlkörper 28 aufgesetzt werden können.

Figur 7 zeigt hierbei einen Summenkühlkörper 28, welcher nur untenseitig Rippen 30 aufweist, so dass die obere Fläche als Montagefläche für eine Systemmontage dienen kann. Figur 8 zeigt die Gruppierung mit einem Summenkühlkörper 28, welcher untenseitig und obenseitig Kühlrippen 30 aufweist, wodurch eine noch größere Kühlkapazität zur Verfügung steht. Ein fester Kontakt der erfindungsgemäßen Kühlkörper 1 mit den Erweiterungs-Summenkühlkörpern 28 kann erfolgen, indem einschiebbare Federkontakte 29 verwendet werden, die die Kühlkörpererweiterungszungen 11 der betreffenden erfindungsgemäßen Kühlkörper 1 gegen eine anliegende Rippe 30 des Summenkühlkörpers 28 drücken. Für eine kraftlose Montage können die Federkontakte 29 mit einem Hilfsmittel vorgespannt sein.

Wie in Figur 8 dargestellt, kann auch ein Summenkühlkörper 28 mit beidseitigen Rippen 30 außenseitig jeweils Erweiterungslaschen 31 zum Anschluss an andere Summenkühlkörper aufweisen. Mittels bereits bekannter Klammerverbindungselemente können über diese Verbindungslaschen 31 mehrere Summenkühlkörper 28 untereinander verbunden werden. Bei einer entsprechenden Anzahl von stehend angeordneten erfindungsgemäßen Kühlkörpern 1 kann so auch eine große Fläche von einzelnen Summenkühlkörpern 28 gebildet werden, die in einer Art Parkettierung aneinandergelegt sind und gemeinsam die im passenden Rastermaß darunter befindlichen Kühlkörper 1 mit den daran angeordneten Leistungsbauelementen 31, 3b kühlen.

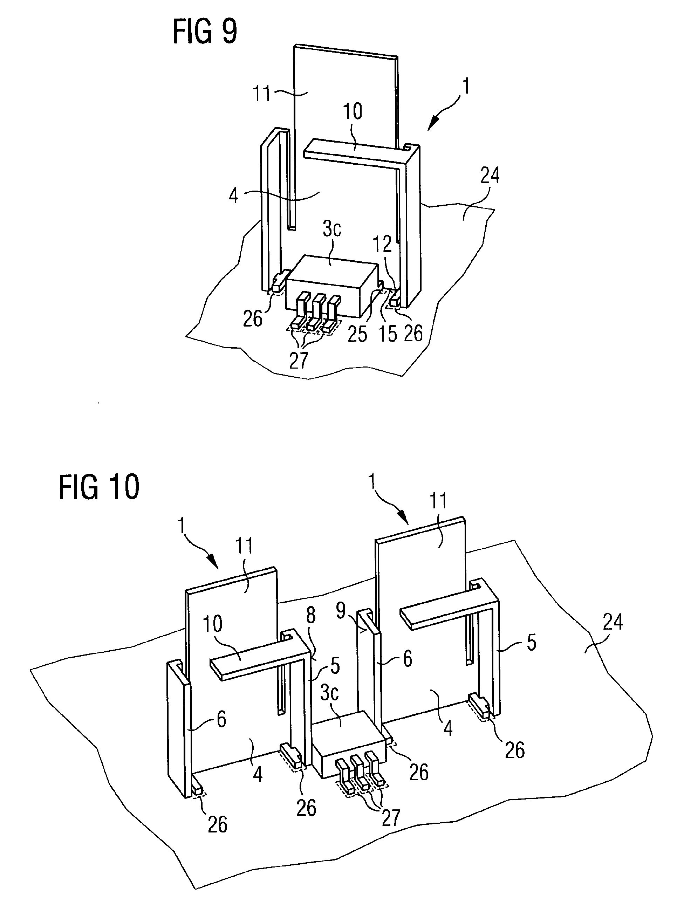

Die Figuren 9 bis 12 zeigen verschiedene Ausführungsbeispiele, wie mit dem erfindungsgemäßen Kühlkörper 1 typische SMD-Leistungsbauteile 3c gekühlt werden können.

Ein solches SMD-Bauelement 3c ist, wie in den Figuren dargestellt, in der Regel über Kontaktpads 25, 27 mit der Schaltung elektrisch verbunden und wird gleichzeitig durch die Verlötung an diesen Kontaktpads 25, 27 fest mit der Leiterplatte 24 verbunden. Für die Kühlung solcher SMD-Bauelemente 3c gibt es üblicherweise zwei verschiedene Varianten.

Die eine Variante besteht darin, dass das Bauelement 3c von unten, d. h. indirekt über das Kontaktpad 25 gekühlt wird. Hierbei gibt das Bauelement 3c die Wärme über den Kontaktpad 24 unter dem Bauelement 3c ab. Die Kühlkörper 1 nehmen die Wärme über die Pad-Wärmeanbindung 25 , 26 - wenn möglich über die die Kühlkörperkontaktfläche 7 bildende Wandung 4 - auf und führen die Wärme ab.

Figur 9 zeigt ein erstes Ausführungsbeispiel dieser erste Variante. Hier ist der erfindungsgemäße Kühlkörper 1 aufrecht stehend so an Kontaktpads 26 auf der Leiterplatte 24 befestigt, dass gleichzeitig auch die Unterkante 15 der die (Haupt-)Kühlkörperkontaktfläche bildenden Wandung 4 auf dem Kontaktpad 25 des Bauelements 3c aufliegt und somit als Kühlkörperkontaktfläche für diesen Einsatzzweck dient.

Bei einem zweiten Ausführungsbeispiel gemäß Figur 10 zu dieser ersten Variante, erfolgt die Kühlung durch zwei Kühlkörper 1, die mit ihren Kontaktpads 26 und soweit möglich mit den die Kühlkörperkontaktflächen 7 bildenden Wandungen 4 die Wärme aufnehmen und abführen.

Sowohl bei dem Ausführungsbeispiel gemäß Figur 9 als auch bei dem Ausführungsbeispiel gemäß Figur 10 kann die Bestückung in üblicher Weise mit einem SMT-Bestückungsautomaten erfolgen. Hier ist jeweils wieder eine Kühlkapazitätserweiterung mit einem Summenkühlkörper, wie in den Figuren 7 und 8 dargestellt, möglich.

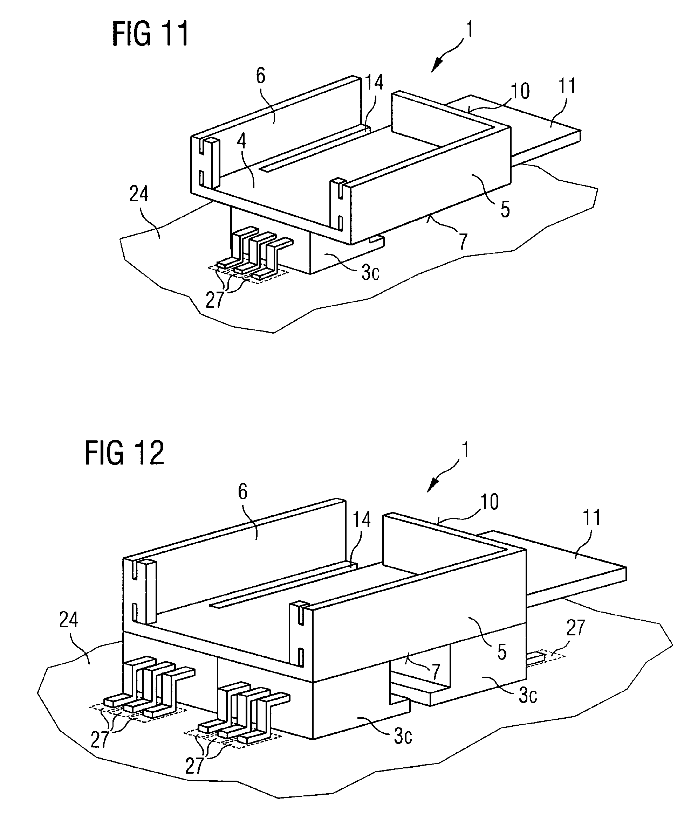

Bei einer zweiten Variante gemäß den Figuren 11 und 12 wird der Kühlkörper 1 in liegender Form mit seiner Kühlkörperkontaktfläche 7 von oben auf das zu kühlende Bauelement 3c aufgesetzt. Dabei kann der Kühlkörper 1 beispielsweise mit Wärmeleitkleber auf das zu kühlende Bauteil 3c aufgeklebt werden.

Wie in Figur 12 dargestellt, ist es auch möglich, dass ein Kühlkörper 1 auf eine Gruppe von aneinander passend positionierten SMD-Leistungshalbleitern 3c aufgesetzt wird und daher gemeinsam diese Gruppe kühlt.

Auch bei dieser liegenden Bauweise nach den Figuren 11 und 12 ist im Prinzip eine Bestückung mit einem SMT-Bestückungsautomaten möglich, da die SMT-Pipette hier ja auf der Innenseite der die Kühlkörperkontaktfläche 7 bildenden Wandung 4 des Kühlkörpers 1 angreifen kann. Es ist hierzu lediglich erforderlich, die Kühlkörper 1 dem Bestückungsautomaten in liegender Form, z. B. in einem Palettenmagazin, zuzuführen

Die Ausführungsbeispiele zeigen die besonders große Variabilität des erfindungsgemäßen Kühlkörpers bezüglich des Einsatzbereichs. Insbesondere durch die Möglichkeit, den Kühlkörper modular zu verwenden, ergeben sich nahezu unbegrenzte Möglichkeiten, den Kühlkörper zur Kühlung der verschiedensten Bauelemente einzusetzen, wobei in nahezu jeder Variante eine automatische Bestückung möglich ist. Durch die Möglichkeit der Klammerung ist der Aufwand zur Sicherstellung eines guten Kontakts des Kühlkörpers 1 zu dem zu kühlenden Bauteil 3a, 3b außerordentlich gering. Zudem können sowohl der Kühlkörper 1 selbst als auch das Klammerelement 2 besonders kostengünstig aus einfachen Metallblechzuschnitten gebogen werden.

## Patentansprüche

1. Kühlkörper (1) für elektronische Bauteile (3a, 3b, 3c) mit einer Kühlkörperkontaktfläche (7) zum Kontakt des Kühlkörpers (1) mit einem zu kühlenden Bauteil (3a, 3b, 3c),
**gekennzeichnet durch**
zumindest eine im Wesentlichen rechtwinklig zu der Kühlkörperkontaktfläche (7) an einer Unterseite des Kühlkörpers (1) angeordnete SMT-Befestigungsfläche (12) und eine im Wesentlichen rechtwinklig zu der Kühlkörperkontaktfläche (7) oberhalb der SMT-Befestigungsfläche (12) am Kühlkörper (1) angeordnete Saugfläche (10) für eine SMT-Pipette.

2. Kühlkörper nach Anspruch 1,
**dadurch gekennzeichnet, dass**
die SMT-Befestigungsfläche (12) über ein die Wärmeleitung behinderndes Element (13) mit dem Kühlkörper (1) verbunden ist.

3. Kühlkörper nach Anspruch 2,
**dadurch gekennzeichnet, dass**
die SMT-Befestigungsfläche (12) über einen dünnen Steg (13) mit dem Kühlkörper verbunden ist.

4. Kühlkörper nach einem der Ansprüche 1 bis 3,
**dadurch gekennzeichnet, dass**
der Kühlkörper (1) in einer parallel zur SMT-Befestigungsfläche (12) liegenden Ebene ein im Wesentlichen U-förmiges Profil aufweist, wobei eine Außenseite der die U-Grundfläche bildenden Wandung (4) des U-Profils die Kühlkörperkontaktfläche (7) bildet und die die U-Schenkel bildenden Seitenwandungen (5, 6) des U-Profils außenseitig zwei Seitenflächen (8, 9) des Kühlkörpers (1) bilden.

5. Kühlkörper nach Anspruch 4,
**dadurch gekennzeichnet, dass**
an jeder der beiden Seitenwandungen (5, 6) an einem unteren Ende jeweils eine SMT-Befestigungsfläche (12) angeordnet ist.

6. Kühlkörper nach Anspruch 5,
**dadurch gekennzeichnet, dass**
die SMT-Befestigungsflächen (12) von den unteren Enden der beiden Seitenwandungen (5, 6) aus in eine durch das U-Profil definierte Grundfläche hineinragen.

7. Kühlkörper nach einem der Ansprüche 4 bis 6,
**dadurch gekennzeichnet, dass**
eine untere Kante (15) der die U-Grundfläche bildenden Wandung (4) als eine zweite Kühlkörperkontaktfläche nach unten bündig mit den SMT-Befestigungsflächen (12) abschließt.

8. Kühlkörper nach einem der Ansprüche 4 bis 7,
**dadurch gekennzeichnet, dass**
die Saugfläche (10) des Kühlkörpers (1) an einem oberen Ende zumindest einer der Seitenwandungen (5, 6) angeordnet ist.

9. Kühlkörper nach Anspruch 8,
**dadurch gekennzeichnet, dass**
die Saugfläche (10) sich von dem oberen Ende der betreffenden Seitenwandung (5) aus in Richtung des oberen Endes der anderen Seitenwandung (6) hin erstreckt.

10. Kühlkörper nach Anspruch 8 oder 9,
**dadurch gekennzeichnet, dass**
die Saugfläche (10) sich in einem Abstand (a) zu der die U-Grundfläche bildenden Wandung (4) erstreckt.

11. Kühlkörper nach einem der Ansprüche 1 bis 10,
**dadurch gekennzeichnet, dass**
die die Kühlkörperkontaktfläche (7) bildende Wandung (4) unter Bildung einer Kühlkörpererweiterungszunge (11) sich zumindest in einem Teilbereich über die Saugfläche (10) und/-oder die oberen Enden der Seitenwandungen (5, 6) des Kühlkörpers (1) hinaus nach oben erstreckt.

12. Kühlkörper (1) für elektronische Bauteile (3a, 3b) mit einer Kühlkörperkontaktfläche (7) zum Kontakt des Kühlkörpers (1) mit dem zu kühlenden Bauteil (3a, 3b),
**gekennzeichnet durch**
zumindest einen sich von einer Oberseite des Kühlkörpers (1) aus in eine die Kühlkörperkontaktfläche (7) bildende Wandung (4) hinein erstreckenden Aufnahmeschlitz (14) zur Aufnahme eines Klammerelements (2) zum Festklammern des betreffenden Bauteils (3a, 3b) gegen die Kühlkörperkontaktfläche (7).

13. Kühlkörper nach Anspruch 12,
**dadurch gekennzeichnet, dass**
der Aufnahmeschlitz (14) parallel zu einer an die Kühlkörperfläche (7) angrenzenden Seitenfläche (8, 9) des Kühlkörpers (1) verläuft.

14. Kühlkörper nach Anspruch 12 oder 13,
**gekennzeichnet durch**
mehrere parallel verlaufende Aufnahmeschlitze (14).

15. Kühlkörper nach Anspruch oder 14,
**gekennzeichnet durch**
zwei im Wesentlichen rechtwinklig zu der Kühlkörperkontaktfläche (7) angeordnete Seitenflächen (8, 9) und jeweils in einem kurzen Abstand zu den Seitenflächen (8, 9) verlaufende Aufnahmeschlitze (14).

16. Kühlkörper nach einem der Ansprüche 1 bis 11 und einem der Ansprüche 12 bis 15.

17. Kühlkörper nach Anspruch 16,
**dadurch gekennzeichnet, dass**
die die Kühlkörperkontaktfläche (7) bildende Wandung (4) sich in einem Teilbereich zwischen den beiden Aufnahmeschlitzen (14) über die Saugfläche (10) und/oder die oberen Enden der Seitenwandungen (5, 6) des Kühlkörpers (1) hinaus nach oben erstreckt.

18. Kühlkörper nach einem der Ansprüche 1 bis 17,
**dadurch gekennzeichnet, dass**
der Kühlkörper (1) aus Messing, Bronze oder Kupfer besteht.

19. Kühlkörper nach einem der Ansprüche 1 bis 18,
**dadurch gekennzeichnet, dass**
der Kühlkörper (1) einteilig aus einem Blechzuschnitt gebogen ist.

20. Kühlkörper nach einem der Ansprüche 1 bis 19,
**dadurch gekennzeichnet, dass**
der Kühlkörper (1) verzinnt ist.

21. Klammerelement (2) zum Einstecken in einen Aufnahmeschlitz (14) in einen Kühlkörper (1) nach einem der Ansprüche 12 bis 20 zum Festklammern eines elektronischen Bauelements (3a, 3b) an dem Kühlkörper (1), mit
- einem Einstecksteg (16), welcher bezüglich seiner Dicke an eine Breite des Aufnahmeschlitzes (14) des Kühlkörpers (1) und bezüglich seiner Länge an eine Dicke der die Kühlkörperkontaktfläche (7) bildenden Wandung (4) und eine Dicke eines festzuklammernden elektronischen Bauelements (3a, 3b) angepasst ist,
- zumindest einem an einem Ende des Einsteckstegs (16) angeordneten Andruckelement (17), welches im montierten Zustand gegen das elektronische Bauelement (3a, 3b) drückt,
- und zumindest einem in dem anderen Endbereich des Einsteckstegs (16) angeordneten Wiederlagerelement (20, 21, 22, 23), welches im montierten Zustand an der die Kühlkörperkontaktfläche (7) bildenden Wandung (4) des Kühlkörpers (1) anliegt.

22. Klammerelement nach Anspruch 21,
**gekennzeichnet durch**
zwei Wiederlagerelemente (20, 21, 22, 23), die sich jeweils rechtwinklig vom Einstecksteg (14) aus und rechtwinklig zu einer Einsteckrichtung (R) in einander entgegengesetzte Richtungen erstrecken.

23. Klammerelement nach Anspruch 21 oder 22,
**gekennzeichnet durch**
zwei Wiederlagerelemente (20, 21), die sich in parallelen Ebenen in einem Abstand zueinander erstrecken, welcher an eine Dicke der die Kühlkörperkontaktfläche (7) bildenden Wandung (4) des Kühlkörpers (1) angepasst ist.

24. Set aus zumindest einem Kühlkörper (1) nach einem der Ansprüche 12 bis 20 und zumindest einem Klammerelement (2) nach einem der Ansprüche 21 bis 23.

25. Elektronische Schaltung mit zumindest einem auf einer Leiterplatte (24) montierten elektronischen Bauteil (3a, 3b, 3c),
**gekennzeichnet durch**
zumindest einen mit dem elektronischen Bauteil (3a, 3b, 3c) über eine wärmeleitende Verbindung verbundenen Kühlkörper (1) nach einem der Ansprüche 1 bis 20.

26. Schaltung nach Anspruch 25,
**dadurch gekennzeichnet, dass**
der Kühlkörper (1) in einer stehenden Bauweise auf der Leiterplatte montiert ist, wobei die Kühlkörperkontaktfläche (7) im Wesentlichen rechtwinklig auf der Montageoberfläche der Leiterplatte (24) steht.

27. Schaltung nach Anspruch 26,
**dadurch gekennzeichnet, dass**
das zu kühlende elektronische Bauelement (3a, 3b, 3c) an der Kühlkörperkontaktfläche anliegt.

28. Schaltung nach Anspruch 26,
**dadurch gekennzeichnet, dass**
der Kühlkörper (1) mit einer eine zweite Kühlkörperkontaktfläche bildenden Unterkante (15) einer Wandung (4) des Kühlkörpers (1) auf einem Kontaktpad (25) der Leiterplatte (24) für das zu kühlende Bauelement (3c) aufliegt.

29. Schaltung nach Anspruch 25,
**dadurch gekennzeichnet, dass**
der Kühlkörper (1) in einer liegenden Bauweise mit der Kühlkörperkontaktfläche (7) auf dem zu kühlenden elektronischen Bauteil (3c) aufliegt.

30. Schaltung nach einem der Ansprüche 25 bis 29,
**gekennzeichnet durch**
mehrere modulartig mit ihren Seitenflächen aneinandergereihte Kühlkörper (1), wobei die Kühlkörperkontaktflächen (7) der Kühlkörper (1) in einer Flucht sind.

31. Schaltung nach einem der Ansprüche 25 bis 30,
**gekennzeichnet durch**
zumindest einen an dem Kühlkörper (1) oder den Kühlkörpern (1) befestigten Erweiterungskühlkörper (28).

32. Schaltung nach Anspruch 31,
**dadurch gekennzeichnet, dass**
der Erweiterungskühlkörper (28) an einer Kühlkörpererweiterungszunge (11) des Kühlkörpers (1) befestigt ist.
